# EUROPÄISCHE PATENTSCHRIFT

(11) **EP 0 798 787 B1**
(45) Veröffentlichungstag und Bekanntmachung des Hinweises auf die Patenterteilung: **21.11.2007**
(21) Anmeldenummer: 97105167.7
(22) Anmeldetag: 26.03.1997
(51) Int. Cl.: H01L 31/048, H01L 31/042

(54) **Photovoltaisches Solarmodul in Plattenform**
Photovoltaic solar module in a plate form
Module solaire photovoltaïque sous forme de panneau

(30) Priorität: 26.03.1996 DE 29605510 U
(43) Veröffentlichungstag der Anmeldung: 01.10.1997
(73) Patentinhaber: Scheuten Solar Technology GmbH, 45884 Gelsenkirchen (DE)
(72) Erfinder: Wambach, Karsten, Dr., 40885 Ratingen (DE); Van de Venne, Olaf, 51503 Rösrath (DE)
(74) Vertreter: Jostarndt, Hans-Dieter

(56) Entgegenhaltungen:
- EP-A- 0 609 651
- DE-A- 2 942 328
- US-A- 4 029 942
- US-A- 4 097 308
- US-A- 5 213 627

## Beschreibung

Die Erfindung betrifft ein photovoltaisches Solarmodul in Plattenform, insbesondere zur Verwendung als Fassaden- oder Dachelement, mit einer dem einfallenden Licht zugewandten Außenscheibe, wenigstens einer in Lichteinfallrichtung dahinter unter Erzeugung eines Scheibenzwischenraumes mit Abstand angeordneten Innenplatte, einem die Außenscheibe und die Innenplatte umlaufend dicht miteinander verbindenden Randaufbau und zwischen der Außenscheibe und der Innenplatte angeordneten, in Gießharz, Verbundfolie(n) oder dergleichen eingebetteten Solarzellen mit einem diese elektrisch verschaltenden Leitersystem, von dem Anschlußleitungen zum elektrischen Verbinden mit benachbarten weiteren Solarmodulen in den Bereich des Randes führen.

Solarmodule dieser Art werden in der Regel unter mechanischer und elektrischer Verbindung zu Solar-Fassadenflächen oder Solar-Dacheindeckungen zusammengesetzt. Es werden dabei die elektrischen Kontaktflächen durch entsprechende elektrische Verbindungsstücke miteinander verbunden; getrennt hiervon ist die mechanische Verbindung benachbarter Solarmodule vorzunehmen.

Bei den in der DE-A 41 40 682 beschriebenen Solarmodulen ist ein elektrisches Kontaktstiftsystem in einem den Plattenaufbau umgebenden Rahmen vorgesehen, wobei der Rahmen mit einem in mechanischer als auch in elektrischer Hinsicht komplementär ausgebildeten Rahmen in Eingriff zu bringen ist.

Aus der DE-U 72 27 856 ist es für im Kraftfahrzeugbau eingesetzte Verbundglasscheiben bekannt, eingebettete elektrische Leitungen, die Antennen oder Alarmeinrichtungen versorgen, über eine Anschlußfahne einer Anschlußhülse oder mehreren Anschlußhülsen zuzuführen, die als Steckkontaktbuchsen ausgebildet sein können. Die Anschlußfahne ist in die Verbundschicht eingelassen.

Eine ähnliche Verbundglasscheibe ist aus der US-A 4,799,346 bekannt, bei der ein außerhalb der Scheibe liegender zweipoliger Stecker über eine Anschlußfahne an einen elektrischen Verbraucher angeschlossen ist, welcher sich innerhalb des Glasverbundes befindet. Verschiedene Anordnungen der Stecker sind auch in der US-A 4,029,942 offenbart.

Grundsätzlich würde ein Herausführen der elektrischen Anschlußleitungen über eine Anschlußfahne eine kostengünstige Alternative zu der in der DE-A 41 40 682 vorgeschlagenen Lösung sein. Allerdings müßte in Kauf genommen werden, daß die elektrische Verschaltung der verschiedenen Solarmodule von einem Elektrofachmann vorgenommen wird, da eine eindeutige Zuordnung der lose abhängenden elektrischen Anschlußleitungen dem üblicherweise mit der Installation von photovoltaischen Solar-Eindeckungen befaßten Baupersonal nicht überlassen werden kann.

Ein weiteres Solarmodul ist aus US 4,097,308 bekannt.

Es ist die Aufgabe der Erfindung, ein Solarmodul der eingangs genannten Art zur Verfügung zu stellen, dessen elektrisches Anschlußsystem eine hohe mechanische Stabilität aufweist und so gestaltet ist, daß die elektrische Verschaltung zwangsläufig fehlerfrei erfolgen kann.

Diese Aufgabe wird von einem Solarmodul nach Anspruch 1 gelöst. Vorteilhafte Ausgestaltungen sind Gegenstand der Unteransprüche.

Erfindungsgemäß ist vorgesehen, daß Anschlußleitungen an einer in den Scheibenzwischenraum ragenden, in das Gießharz oder die Verbundfolie(n) eingebetteten Anschlußfahne, welche mit einer sich außerhalb des Plattenaufbaus erstreckenden Isolierhülse verbunden ist, befestigt und aus dem Plattenaufbau herausgeführt sind, wobei an einem Ende der Isolierhülse ein erstes Anschlußelement und an dem gegenüberliegenden Ende der Isolierhülse ein zweites Anschlußelement vorgesehen ist, wobei die Anschlußelemente mit jeweils einer durch die Isolierhülse gelegten Anschlußleitung verbunden und mit entsprechenden Anschlußelementen benachbarter Solarmodule verschaltbar sind.

Die Erfindung ermöglicht, daß auch Baupersonal, dem das elektrische Verschalten von Bauelementen weniger geläufig ist, durch einfaches Zusammenfügen der Module unter Verwendung der hülsenendseitigen Anschlußelemente solartechnische Systeme, z.B. an Fassaden oder auf Dächern, installieren kann.

Bevorzugt erstreckt sich die Isolierhülse entlang einer Kante des Plattenaufbaus und weiter bevorzugt im wesentlichen über die gesamte Länge der Kante. Mit dieser Ausgestaltung wird zweierlei erreicht: zum einen kann die Isolierhülse bei einer satten Anlage an die Kante keine Hebelwirkung auf die Anschlußfahne ausüben, so daß einer unabsichtlichen. Zerstörung bei rauher Handhabung vorgebeugt wird, weiter stehen sich die zu verschaltenden Anschlußelemente gegenüber bzw. greifen beim Zusammensetzen der Module ohne weitere Maßnahmen ineinander.

Dabei ist bevorzugt eines der Anschlußelemente als Buchse und das andere als komplementärer Stecker ausgebildet.

Um möglicherweise auftretende Belastungen, insbesondere bei der Montage, aufzufangen, kann vorgesehen sein, daß die Isolierhülse einen elastischen Abschnitt aufweist, der sich zumindest über einen Teil ihrer Länge und Breite erstreckt.

Nach einer bevorzugten Ausführungsform sollen die Anschlußfahne und die Isolierhülse eine gemeinsame Baueinheit bilden, die weiter bevorzugt durch Spritzgießen hergestellt wird.

Eine weitere Ausgestaltung sieht die Bestückung der Isolierhülse mit einer Diode vor, die sich in Parallelschaltung zu der Solarzellenanordnung zwischen den an der Anschlußfahne befestigten elektrischen Anschlüssen befindet. Mit einer solchen Diode, auch Bypass-Diode genannt, wird bei einem elektrischen Defekt innerhalb des Moduls dieses überbrückt, so daß das solartechnische System, wenn auch mit verminderter Leistung, weiterhin arbeiten kann. Üblicherweise ist eine Bypass-Diode in der elektrischen Anschlußdose des Moduls angeordnet. Mit der erfindungsgemäßen Anordnung wird die elektrische Verschaltung des Moduls vereinfacht. Bevorzugt ist die Isolierhülse zum Austausch der Diode öffenbar ausgestaltet.

Vorzugsweise sind die elektrisch leitenden Teile der Anschlußelemente von einer Isolierung umgeben, die einen Berührungsschutz gewährleistet, so daß ohne die Gefahr, mit elektrisch leitenden Teilen in Berührung zu kommen, Arbeiten mit den erfindungsmäßig bestückten Modulen durchgeführt werden können.

Weiterhin kann die Anschlußfahne einen oder mehrere Fortsätze aufweisen, die eine zugsichere Verbindung der Anschlußfahne mit dem Doppelglasverbund gewährleisten; insbesondere wird diese Verbindung durch das Eingreifen der Fortsätze in die Gießharzschicht hergestellt. Somit sind die wertvollen solartechnischen Module vor der meist irreversiblen Beschädigung bei Herausreißen der Anschlüsse geschützt. Derartige Fortsätze sind bevorzugt am der Mitte des Plattenaufbaus zugewandten Ende der Anschlußfahne vorgesehen und erstrecken sich über die größtmögliche Länge der Kante der Anschlußfahne, wobei sie in Normalenrichtung des Plattenaufbaus von der Anschlußfahne hervorstehen. Aus der US-A 4,799,346 ist es bekannt, Fahnen, die zur Befestigung der Verbundglasscheibe an einem Rahmen dienen, mit derartigen Fortsätzen zu versehen. Es ist aber bisher nicht daran gedacht worden, die elektrischen Anschlüsse direkt durch eine solche Maßnahme zu schützen.

Als Außenscheibe kann eine Silikatglasscheibe, vorzugsweise eine Weißglasscheibe, eingesetzt werden.

Als Innenplatte ist ebenfalls eine Silikatglasscheibe zweckmäßig.

Als Material zum Einbetten der Solarzellen wird Polyvinylbutyral (PVB), Ethylenvinylacetat (EVA) oder eine Monomermischung auf Acrylatbasis verwendet.

Die Erfindung bildet auch die Grundlage für ein baukastenartiges Verschaltungssystem für Solarmodul-Anordnungen. Es können dazu als Komponenten für den elektrischen Anschluß Kombinationen aus Isolierhülse, Stecker, Anschlußfahne mit Fortsätzen und Anschlußleitungen bereitgestellt werden; statt des Steckers kann eine Buchse vorhanden sein usw. Diese Komponenten können beispielsweise zur Verschaltung von am Rand der Eindeckung angebrachten Solarmodulen verwendet werden.

Im folgenden wird die Erfindung anhand der beigefügten Zeichnungen näher beschrieben. Es zeigt:
- Figur 1: eine Schnittansicht eines elektrischen Anschlußsystems für Solarmodule gemäß der vorliegenden Erfindung in der in Fig. 2 mit I angegebenen Schnittrichtung;
- Figur 2: zeigt eine Schnittansicht, teilweise weggebrochen, eines Solarmoduls gemäß der Erfindung in der in Fig. 1 mit II angegebenen Blickrichtung;
- Figur 3 bis 7: zeigen mögliche Komponenten für ein Baukastensystem zur Verwendung mit Solarmodulen nach der Erfindung; und
- Figur 8: ein elektrisches Anschlußsystem mit einer Isolierhülse mit elastischem Zwischenabschnitt.

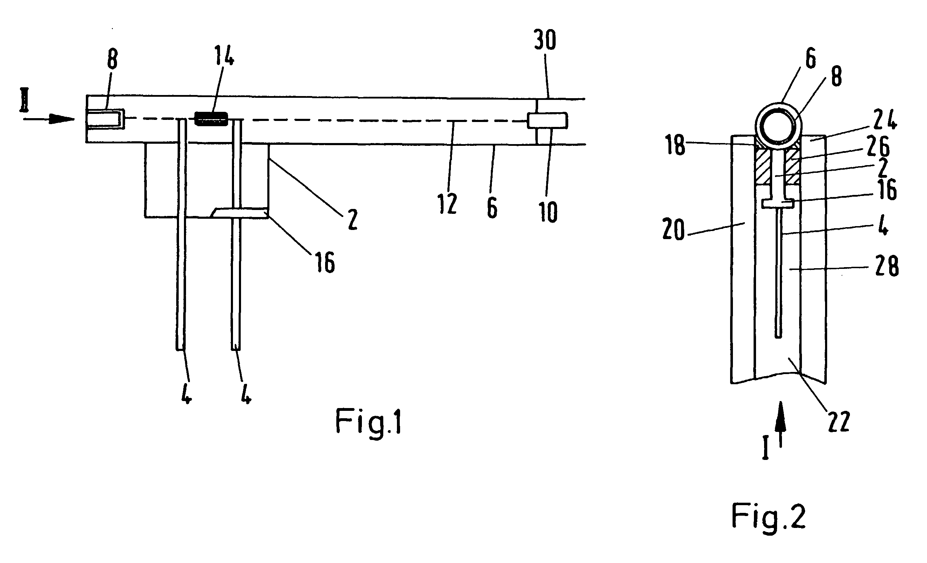

Wie Fig. 1 erkennen läßt, weist das elektrische Anschlußsystem des Solarmoduls gemäß der Erfindung eine Anschlußfahne 2 auf, aus der Anschlußleitungen 4 mit freien Enden ragen, welche mit nicht dargestellten, in Gießharz oder Folie(n) 28 eingebetteten Solarzellen elektrisch verschaltet sind. Die Anschlußfahne 2 ist starr mit einer hohlzylindrischen Isolierhülse 6 verbunden, die sich bevorzugt über die gesamte Länge eines Moduls erstreckt. An einem Ende der Isolierhülse 6 ist eine zentrisch liegende Buchse 8 und am gegenüberliegenden Ende ein zur Buchse komplementärer, von einem Berührungsschutz 30, als Hohlzylinder ausgebildet, umgebener Stecker 10 angeordnet. Die elektrischen Anschlußleitungen 4 sind durch elektrische Leitungen 12 zu dem Stecker 10 bzw. zu der Buchse 8 geführt.

In Parallelschaltung zu den elektrischen Anschlußleitungen 4 ist eine Diode 14 als Bypass-Diode für die in dem Solarmodul untergebrachte Solarzellenanordnung in die Isolierhülse 6 eingefügt. Vorzugsweise ist die Isolierhülse 6 im Bereich der Diode 14 öffenbar ausgeführt, zum Beispiel durch Anordnung einer mittels Schraube verschließbaren Klappe (nicht gezeigt). Abweichend von der Schnittansicht ist ein Teil eines Fortsatzes 16 gezeigt, welcher sich über die gesamte Breite der Anschlußfahne 2 erstreckt.

Fig. 2 zeigt das Anschlußsystem in einem Verbundglasaufbau mit einer ersten Glasscheibe 20 und einer zweiten Glasscheibe 24 sowie dazwischen angeordneter Gießharzschicht 28. Die Isolierhülse 6 ruht auf dem Rand des Plattenaufbaus, gegebenenfalls teilweise in Versiegelungsmasse 18 eingebettet. Die Anschlußfahne 2 ist durch bei der Solarmodulherstellung ohnehin zu verwendendes Dichtband 26 positioniert und wird durch das Gießharz 28 im Scheibenzwischenraum 22 fixiert. Die Anschlußfahne 2 ist bei dieser Ausführungsform mit zwei einander gegenüberstehenden Fortsätzen 16 an ihrer randabgewandten Seite versehen. Die Fortsätze 16 können verschiedene Formen haben, z.B. hakenartig ausgestaltet oder mit strukturierter bzw. aufgerauhter Oberfläche versehen sein, um durch innigen Kontakt mit der umgebenden Gießharzmasse im Scheibenzwischenraum 22 eine gute Zugsicherung zu gewährleisten. Haftverrnittler können vorgesehen sein, um den Kontakt zwischen Gießharz und Anschlußfahne 2 weiter zu verbessern, auch kann die Anschlußfahne 2 Oberflächenstrukturierungen, ähnlich denen der Fortsätze 16, aufweisen.

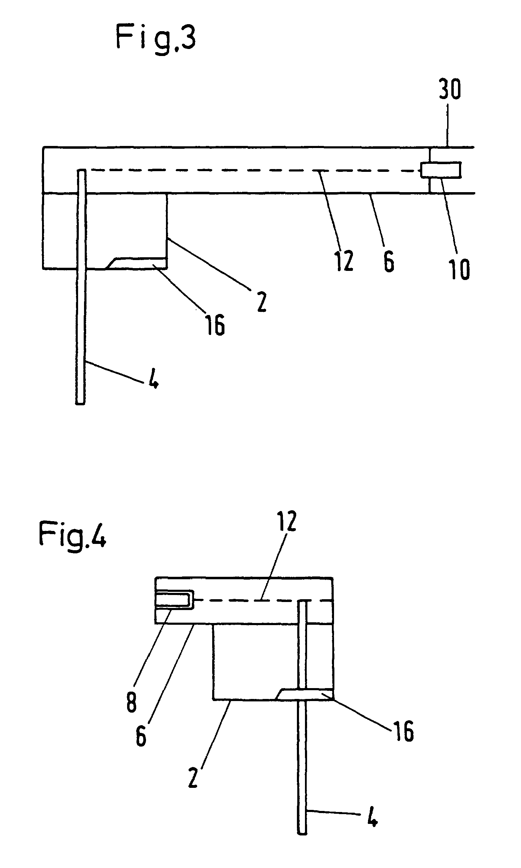

Die Figuren 3 bis 7 stellen Komponenten für ein baukastenartiges Verschaltungssystem dar. Diese Komponenten können für erforderliche Sonderverschaltungen zusätzlich zu den Ve=schaltungsmöglichkeiten durch das erfindungsgemäße Solarmodul selbst verwendet werden.

Figur 3 zeigt ein Ausführungsbeispiel, bestehend aus einer Anschlußfahne 2 mit teilweise dargestelltem Fortsatz 16, die an einer Isolierhülse 6 befestigt ist und eine elektrische Anschlußleitung 4 trägt. Eine elektrische Leitung 12 ist durch die Isolierhülse 6 geführt und verbindet die Anschlußleitung 4 mit dem Stecker 10.

Figur 4 zeigt eine zu Figur 3 im Sinne von Figur 1 komplementäre Komponente, sie besteht aus den gleichen Bauteilen wie die Komponente der Figur 3, mit der Ausnahme, daß an entsprechender Stelle eine Buchse 8 anstatt eines Steckers vorgesehen ist.

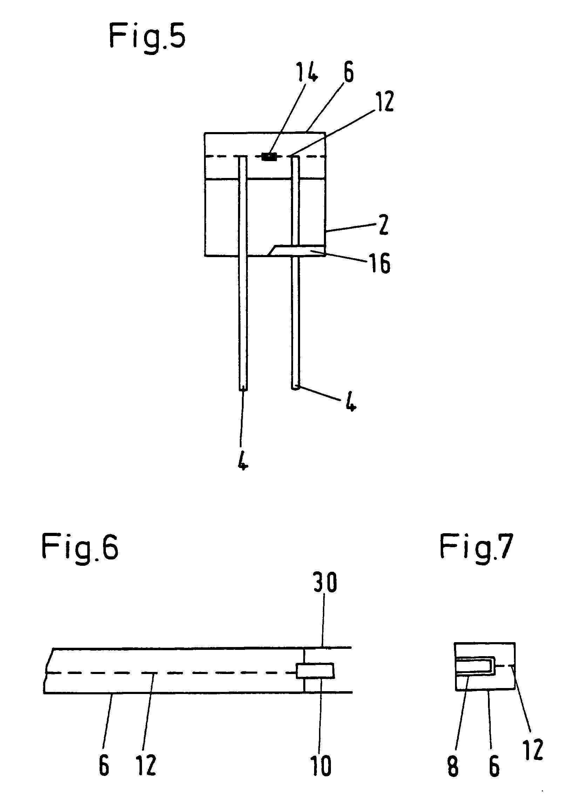

Figur 5 ist eine Darstellung einer Komponente mit Anschlußfahne 2 und Fortsatz 16, bei der die elektrischen Anschlußleitungen 4 durch eine Diode 14, die in der Isolierhülse 6 angeordnet ist, überbrückt sind. Wegführende elektrische Leitungen 12 sind angedeutet.

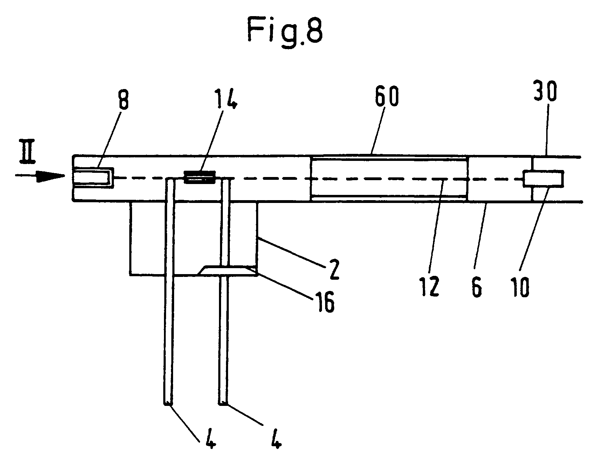

Figur 6 zeigt eine Isolierhülse 6 mit Stecker 10, Figur 7 eine Isolierhülse 6 mit Buchse 8, jeweils mit wegführenden elektrischen Leitungen 12.

Schließlich zeigt Figur 8 eine besondere Ausgestaltung des Aufbaus nach Figur 1, bei dem die Isolierhülse 6 mit einem elastischen Abschnitt 60 versehen ist, der sich über eine gewisse Länge der Isolierhülse 6 erstreckt. Mit diesem elastischen Abschnitt können mechanische Spannungen aufgefangen werden, die sich beispielsweise aus Temperaturänderungen, bei der Montage aufgebrachten Kräften und dergleichen ergeben können.

Die Isolierhülse kann auch in ihrer Außenkontur zumindest bereichsweise im Querschnitt quadratisch ausgebildet werden, so daß eine ebene Auflagefläche entsteht, die beispielsweise auf die der Lichteinfallseite abgewandten Seite der Innenplatte aufgesetzt und dort befestigt, beispielsweise verklebt werden kann. Zweckmäßigerweise erfolgt ein Verkleben nicht nur der Isolierhülse, sondern auch der Anschlußfahne mittels eines hochfesten Klebstoffes oder eines Klebebandes. Die Anschlußleitungen der Solarzellen werden dann durch eine Durchgangsöffnung in der Innenplatte aus dem Scheibenzwischenraum herausgeführt und mit den Anschlüssen der Anschlußfahne verlötet. Die Öffnung und die Isolierhülse werden vorteilhaft mit einer geeigneten Schutzkappe abgedeckt, an der ein die Isolierhülse zumindest teilweise umgreifender Clip vorgesehen sein kann.

Die Erfindung ist im Zusammenhang mit eigensteifen Platten bzw. Glasscheiben beschrieben worden. Es sind aber auch Verbundanordnungen bekannt, bei denen als Innenabdeckung eine Folie verwendet wird. Auch bei solchen Solarzellen-Verbunden kann mit geringer Modifikation die Erfindung angewendet werden. Zweckmäßigerweise wird dazu im Auflagebereich der Isolierhülse auf der rückseitigen Folie eine Versteifungsplatte angeordnet, so daß wieder gewährleistet ist, daß sich die Isolierhülse mechanisch stabil abstützen kann. Es ist auch denkbar, zusätzlich direkt an der Isolierhülse Anlageflächen bereitzustellen, die für ein paßgenaues, verdreh- und verdrillsicheres Ansetzen der Isolierhülse an den Verbund sorgen. Die Versteifungsplatte kann ebenfalls mit einem Clip versehen sein, der die Isolierhülse zumindest teilweise umgreift.

### Bezugszeichenliste

- 2: Anschlußfahne
- 4: Anschlußleitungen
- 6: Isolierhülse
- 8: Buchse
- 10: Stecker
- 12: Elektrische Leitungen
- 14: Diode
- 16: Fortsatz
- 18: Versiegelungsmasse
- 20: Glasscheibe
- 22: Scheibenzwischenraum
- 24: Glasscheibe
- 26: Dichtband
- 28: Gießharz
- 30: Berührungsschutz
- 60: Elastischer Abschnitt

## Patentansprüche

1. Photovoltaisches Solarmodul in Plattenform, insbesondere zur Verwendung als Fassaden- oder Dachelement, mit einer dem einfallenden Licht zugewandten Außenscheibe (20), wenigstens einer in Lichteinfallrichtung dahinter unter Erzeugung eines Scheibenzwischenraumes (22) mit Abstand angeordneten Innenplatte (24), einem die Außenscheibe und die Innenplatte umlaufend dicht miteinander verbindenden Randaufbau und zwischen der Außenscheibe und der Innenplatte angeordneten, in Gießharz oder Verbundfolie(n) eingebetteten Solarzellen mit einem diese elektrisch verschaltenden Leitersystem, von dem Anschlußleitungen (4) zum elektrischen Verbinden mit benachbarten weiteren Solarmodulen in den Bereich des Randes führen,
**dadurch gekennzeichnet,**
**daß** Anschlußleitungen (4) an einer in den Scheibenzwischenraum (22) ragenden, in das Gießharz oder die Verbundfolie(n) eingebetteten Anschlußfahne (2), welche mit einer sich außerhalb des Plattenaufbaus erstreckenden Isolierhülse (6) verbunden ist, befestigt und aus dem Plattenaufbau herausgeführt sind, wobei sich die Isolierhülse (6) entlang der gesamten Länge einer Kante des Plattenaufbaus erstreckt und an einem Ende der Isolierhülse (6) ein erstes Anschlußelement (10) und an dem gegenüber liegenden Ende der Isolierhülse (6) ein zweites Anschlußelement (10) vorgesehen ist, wobei eines der Anschlußelemente als Buchse (8) und das andere als komplementärer Stecker (10) ausgebildet ist und die Anschlußelemente (8;10) mit jeweils einer durch die Isolierhülse (6) gelegten Anschlußleitung (4; 12) verbunden und mit entsprechenden Anschlußelementen benachbarter Solarmodule verschaltbar sind.

2. Solarmodul nach Anspruch 1,
**dadurch gekennzeichnet,**
**daß** die Isolierhülse (6) einen elastischen Abschnitt (60) aufweist, der sich zumindest über einen Teil der Länge der Isolierhülse (6) erstreckt.

3. Solarmodul nach einem oder beiden der Ansprüche 1 und 2,
**dadurch gekennzeichnet,**
**daß** die Anschlußfahne (2) und die Isolierhülse (6) eine gemeinsame Baueinheit bilden.

4. Solarmodul nach einem oder mehreren der Ansprüche 1 bis 3,
**dadurch gekennzeichnet,**
**daß** eine Diode (14), die in Parallelschaltung zu der Solarzellenanordnung zwischen die Anschlußleitungen (4) gelegt ist, im Inneren der Isolierhülse (6) angeordnet ist.

5. Solarmodul nach einem oder mehreren der Ansprüche 1 bis 4,
**dadurch gekennzeichnet,**
**daß** die Isolierhülse (6) zumindest teilweise öffenbar ausgeführt ist.

6. Solarmodul nach einem oder mehreren der Ansprüche 1 bis 5,
**dadurch gekennzeichnet,**
**daß** an den Anschlußelementen (8;10) ein isolierender Berührschutz (30) vorgesehen ist.

7. Solarmodul nach einem oder mehreren der Ansprüche 1 bis 6,
**dadurch gekennzeichnet,**
**daß** die Anschlußfahne (2) mindestens einen Fortsatz (16) aufweist, der sich in den Scheibenzwischenraum (22) erstreckt.

## Claims

1. A photovoltaic solar module in the form of a panel, particularly for use as a façade or roof element comprising an outer sheet (20) facing the incident light, at least one inner panel (24) arranged at a certain distance behind said outer sheet in the direction of the incident light, thus forming a space (22) between the sheets, an edge structure encircling the outer sheet and the inner panel so as to tightly join them to each other, as well as solar cells arranged between the outer sheet and the inner panel and embedded in cast resin or laminated film(s) and having a conductor system that electrically interconnects said solar cells and from which connection lines (4) lead to the edge area so as establish an electrical connection with other, adjacent solar modules,
**characterized in that**
connection lines (4) are attached to a terminal tab (2) which protrudes into the space (22) between the sheets and which is embedded in the cast resin or in the laminated film(s), said terminal tab (2) being connected to an insulating sleeve (6) that extends outside of the panel structure, and said connection lines leading out of the panel structure, whereby the insulating sleeve (6) extends along the entire length of one edge of the panel structure and a first connection element (10) is provided at one end of the insulating sleeve (6) while a second connection element (10) is provided on the opposite end of the insulating sleeve (6), whereby one of the connection elements is configured as a socket (8) while the other is configured as a mating plug (10) and the connection elements (8; 10) are each connected to a connection line (4; 12) that is laid through the insulating sleeve (6) and they can be interconnected with corresponding connection elements of adjacent solar modules.

2. The solar module according to Claim 1,
**characterized in that**
the insulating sleeve (6) has an elastic section (60) that extends along at least part of the length of the insulating sleeve (6).

3. The solar module according to one or both of Claims 1 and 2,
**characterized in that**
the terminal tab (2) and the insulating sleeve (6) form one single unit.

4. The solar module according to one or more of Claims 1 to 3,
**characterized in that**
a diode (14) that is connected in parallel to the solar cell arrangement and that is located between the electrical connections (4) is arranged inside the insulating sleeve (6).

5. The solar module according to one or more of Claims 1 to 4,
**characterized in that**
the insulating sleeve (6) is designed so that it can be at least partially opened.

6. The solar module according to one or more of Claims 1 to 5,
**characterized in that**
insulating shock-hazard protection (30) is provided on the connection elements (8; 10).

7. The solar module according to one or more of Claims 1 to 6,
**characterized in that**
the terminal tab (2) has at least one projection (16) that extends into the space between the sheets (22).

## Revendications

1. Module solaire photovoltaïque sous forme de panneau, en particulier destiné à être utilisé comme élément de façade ou de toit, comprenant une plaque extérieure (20) tournée vers la lumière incidente, au moins une plaque intérieure (24) située à distance de et derrière celle-ci dans le sens de la lumière incidente avec création d'un espace (22) entre les plaques, une structure de bord assemblant la plaque extérieure et la plaque intérieure entre elles périphériquement et de manière étanche, et des cellules solaires, situées entre la plaque extérieure et la plaque intérieure et enrobées dans de la résine coulée ou une/des feuille(s) composite(s), avec un système de conducteurs qui relie celles-ci par câblage électrique et dont des lignes de raccordement (4) vont à la zone du bord pour établir une liaison électrique avec d'autres modules solaires voisins,
**caractérisé en ce que**
des lignes de raccordement (4) sont fixées à une languette de raccordement (2) faisant saillie dans l'espace ménagé entre les plaques (22) et enrobée dans la résine coulée ou la/les feuille(s) composite(s), laquelle languette est assemblée à un manchon isolant (6) qui s'étend en dehors de la structure de plaques, et sortent de la structure de plaques, le manchon isolant (6) s'étendant le long de toute la longueur d'une arête de la structure de plaques et un premier élément de raccordement (10) étant prévu à une extrémité du manchon isolant (6) et un deuxième élément de raccordement (10) étant prévu à l'extrémité opposée du manchon isolant (6), l'un des éléments de raccordement se présentant sous la forme d'une prise femelle (8) et l'autre, sous la forme d'une fiche complémentaire (10) et les éléments de raccordement (8; 10) étant reliés à respectivement une ligne de raccordement (4; 12) qui passe par le manchon isolant (6) et pouvant être reliés par câblage à des éléments de raccordement correspondants de modules solaires voisins.

2. Module solaire selon la revendication 1, **caractérisé en ce que** le manchon isolant (6) comporte une section élastique (60) qui s'étend au moins sur une partie de la longueur du manchon isolant (6).

3. Module solaire selon l'une des ou les deux revendications 1 et 2, **caractérisé en ce que** la languette de raccordement (2) et le manchon isolant (6) constituent un ensemble commun.

4. Module solaire selon l'une ou plusieurs des revendications 1 à 3, **caractérisé en ce qu'**une diode (14), montée en parallèle avec l'ensemble de cellules solaires entre les lignes de raccordement (4), est située à l'intérieur du manchon isolant (6).

5. Module solaire selon l'une ou plusieurs des revendications 1 à 4, **caractérisé en ce que** le manchon isolant (6) est réalisé de manière ouvrable au moins partiellement.

6. Module solaire selon l'une ou plusieurs des revendications 1 à 5, **caractérisé en ce qu'**une protection isolante contre le contact (30) est prévue au niveau des éléments de raccordement (8; 10).

7. Module solaire selon l'une ou plusieurs des revendications 1 à 6, **caractérisé en ce que** la languette de raccordement (2) comporte au moins un prolongement (16) qui s'étend dans l'espace ménagé entre les plaques (22).
